# EUROPÄISCHE PATENTSCHRIFT

(11) **EP 2 804 213 B1**
(45) Veröffentlichungstag und Bekanntmachung des Hinweises auf die Patenterteilung: **04.04.2018**
(21) Anmeldenummer: 14158702.2
(22) Anmeldetag: 11.03.2014
(51) Int. Cl.: H01L 25/07, H05K 7/20, H01L 23/48, H01L 23/473

(54) **Leistungshalbleitermodul und Anordung hiermit**
Semiconductor power module and assembly with the same
Module semi-conducteur de puissance et système doté de celui-ci

(30) Priorität: 14.05.2013 DE 102013104950
(43) Veröffentlichungstag der Anmeldung: 19.11.2014
(73) Patentinhaber: SEMIKRON Elektronik GmbH & Co. KG, 90431 Nürnberg (DE)
(72) Erfinder: Göbl, Christian, 90441 Nürnberg (DE); Popp, Rainer, 91580 Petersaurach (DE); Lederer, Marco, 90453 Nürnberg (DE); Weiß, Stefan, 91315 Höchstadt (DE)

(56) Entgegenhaltungen:
- EP-A2- 1 255 299
- DE-B3-102006 027 482
- US-A- 5 267 867

## Beschreibung

Die Erfindung beschreibt ein Leistungshalbleitermodul mit einer Schalteinrichtung als eine Basiszelle sowie eine Anordnung mit einer Mehrzahl derartiger Leistungshalbleitermodule und eine Kühleinrichtung.

Beispielhaft aus der DE 10 2006 006 425 A1 ist es bekannt ein Leistungshalbleitermodul derart auszubilden, dass Druckeinrichtungen, ausgebildet als Lastanschlusselemente mit jeweils einer Mehrzahl von Kontaktfüßen auf Kontaktstellen eines Substrats Druck ausüben, um einen thermisch leitenden Kontakt zwischen dem Substrat und einer Kühleinrichtung herzustellen. Nachteilig hierbei ist allerdings, dass trotz einer Mehrzahl von Druck ausübenden Kontaktfüßen die thermisch Anbindung nicht optimal ausgebildet ist, da die thermische Anbindung der Abwärme erzeugenden Leistungshalbleiterbauelement nur mittelbar erfolgt.

Die DE 10 2006 027 482 B3 als Stand der Technik beschreibt eine gehauste Halbleiterschaltungsanordnung mit einem Substrat mit Leiterbahnen und hierauf schaltungsgerecht angeordneten Halbleiterbauelementen und mit einer Verbindungseinrichtung. Diese besteht aus einem Folienverbund aus mindestens zwei elektrisch leitenden Schichten mit jeweils einer dazwischen angeordneten isolierenden Schicht, wobei mindestens eine leitende Schicht in sich strukturiert ist und somit Leiterbahnen ausbildet. Die Verbindungseinrichtung kann durch Druckkontaktverbindungen mit den darunterliegenden Halbleiterbauelementen elektrisch verbunden werden. Mindestens eine leitende Schicht weist erste Kontakteinrichtungen zu Anschlussflächen der Halbleiterbauelemente auf. Mindestens ein Teil dieser und / oder einer weiteren leitenden Schicht ist ein Teil mindestens einer zweiten Kontakteinrichtung zur reversiblen Verbindung mit einer externen Zuleitungen. Hierbei weist die zweite Kontakteinrichtung mindestens ein Federelement mit einem Widerlager im Gehäuse und / oder mindestens eine Feststellschraube auf.

Weiterhin ist aus der US 5,267,867 A eine Anordnung mit einer Mehrzahl von integrierten Schaltungen (ICs) bekannt, die kopfüber direkt auf einem flexiblen Schaltungsträger montiert sind. Dieser stellt Verbindungen zwischen den ICs wie auch zu ein Signalträger zur Verfügung. Ein thermisch leitfähige Zwischenlage bedeckt zur Wärmeabfuhr u.a. die Rückseite der ICs, während eine starre Platte elastische Kissen gegen die andere Oberfläche des flexiblen Schaltungsträgers presst um einen thermischen Kontakt sowohl zwischen dem flexiblem Schaltungsträger und den ICs wie auch zwischen den ICs und der Zwischenlage herzustellen.

Aus dem Stand der Technik beispielhaft offenbart in der EP 1 255 299 A2 ist es bekannt auf Verbindungseinrichtungen, jeweils ausgebildet als eine Leiterplatte, eine flexible Leiterplatte oder ein gleichwirkender Folienverbund mit Leiterbahnen, mit einer flächigen Druckeinrichtung zu drücken, die ihrerseits einen elastischen Druckspeicher aufweist, der mittels einer Druckplatte, auf die gesamte Schaltungsanordnung Druck ausübt.

Ebenfalls aus dem Stand der Technik, beispielhaft offenbart in der DE10 2010 62 556 A1, ist eine Halbleiterschaltungsanordnung in Form eines Leistungshalbleitermoduls bekannt, bei der ein Gehäuse ein Druckelement mit einem Druckkörper aufweist, wobei der Druckkörper entweder direkt auf einen Teil eines Halbleiterbauelements oder auf einen Abschnitt eines Substrats drückt. Aus der US 7,808,100 B2 ist es ebenfalls bekannt direkt mittels eines Pressstempels auf Leistungshalbleiterbauelemente zu drücken. Nachteilig an beiden Ausgestaltungen ist, dass ein direkter Druck auf ein Leistungshalbleiterbauelement, das mittels Drahtbondverbindungen intern schaltungsgerecht verbunden ist, auf Grund der in realen Anwendungen begrenzten zur Verfügung stehenden Fläche nur sehr punktuell erfolgen kann, und selbst damit zu Lasten der Stromtragfähigkeit der internen Verbindung geht, da am Druckpunkt keine Bondverbindungen herstellbar sind.

In Kenntnis der genannten Gegebenheiten liegt der Erfindung die Aufgabe zugrunde, ein modular herstellbares Leistungshalbleitermodul mit optimierter Wärmeabfuhrmöglichkeit und eine Anordnung hiermit und mit einer Kühleinrichtung vorzustellen.

Diese Aufgabe wird erfindungsgemäß gelöst durch ein Leistungshalbleitermodul mit den Merkmalen des Anspruchs 1, sowie durch eine Anordnung mit einem derartigen Leistungshalbleitermodul mit den Merkmalen des Anspruchs 9. Bevorzugte Ausführungsformen sind in den jeweiligen abhängigen Ansprüchen beschrieben.

Das erfindungsgemäße Leistungshalbleitermodul ist ausgebildet in Druckkontaktausführung, zur Anordnung auf einem Kühlbauteil, mit einer leistungselektronischen Schalteinrichtung, einem Gehäuse, nach außen führenden ersten Lastanschlusselementen und mit einer ersten Druckeinrichtung, wobei die leistungselektronische Schalteinrichtung ein Substrat mit einem hierauf angeordneten Leistungshalbleiterbauelement, eine interne Verbindungseinrichtung, interne zweite Lastanschlusselemente und eine zweite Druckeinrichtung, aufweist, wobei die Verbindungseinrichtung als Folienverbund aus einer elektrisch leitenden und einer elektrisch isolierenden Folie ausgebildet ist und somit eine erste und eine zweite Hauptfläche ausbildet und wobei die Schalteinrichtung mittels der Verbindungseinrichtung schaltungsgerecht intern elektrisch verbunden ist, wobei die zweite Druckeinrichtung einen Druckkörper mit einer ersten Ausnehmung aufweist aus der ein erstes Druckelement in Richtung der Leistungshalbleiterbauelemente hervorstehend angeordnet ist und wobei der Druckkörper auf einen Abschnitt der zweiten Hauptfläche der Verbindungseinrichtung drückt und hierbei dieser Abschnitt in Projektion entlang der Normalenrichtung des Leistungshalbleiterbauelements innerhalb der Fläche des Leistungshalbleiterbauelements angeordnet ist, wobei die ersten Lastanschlusselemente mit auf der Oberseite des Druckkörpers angeordneten Lastkontaktstellen der zweiten Lastanschlusselemente polaritätsgerecht direkt elektrisch verbunden sind.

Selbstverständlich handelt es sich bei der leistungselektronischen Schalteinrichtung um mindestens eine leistungselektronische Schalteinrichtung.

Unter einer direkten elektrischen Verbindung soll hier ein Verbindung zwischen zwei Kontaktstellen verstanden werden, die zueinander in unmittelbarem Kontakt stehen, also nicht mittels weiterer Elemente miteinander elektrisch verbunden sind. Erfindungsgemäß ist zur thermischen Anbindung des Leistungshalbleiterbauelements an die Kühleinrichtung die erste Druckeinrichtung ausgebildet zur Druckeinleitung auf die ersten Lastanschlusselemente, über diese auf die zweiten Lastanschlusselemente, weiter über die zweite Druckeinrichtung und die Verbindungseinrichtung auf das Leistungshalbleiterbauelement.

Grundsätzlich können die ersten Lastanschlusselemente jeweils als elektrisch gegeneinander isolierte flächige Metallformkörper mit mindestens einem bandartigen Abschnitt mit einer Mehrzahl von diesem ausgehenden Kontaktelementen zur Kontaktierung der Lastkontaktstellen ausgebildet sein, wobei die bandartigen Abschnitte der Lastanschlusselemente parallel zum Substrat und von diesem beabstandet angeordnet sind und somit einen Stapel ausbilden.

Vorteilhafterweise weist das Substrat gegeneinander elektrisch isolierte Leiterbahnen auf, wobei auf einer Leiterbahn das Leistungshalbleiterbauelement angeordnet und stoffschlüssig damit verbunden ist.

Besonders bevorzugt ist es, wenn der Druckkörper aus einem hochtemperaturbeständigen thermoplastischen Kunststoff, insbesondere aus Polyphenylensulfid, und das Druckelement aus einem Silikonkautschuk, insbesondere aus Flüssig-Silikon, besteht.

Vorteilhafterweise weist der Flächeninhalt des Abschnitts der Verbindungseinrichtung mindestens 20%, insbesondere mindestens 50% der Fläche des Leistungshalbleiterbauelements auf.

Die erfindungsgemäße Anordnung weist eine Mehrzahl von oben beschriebenen Leistungshalbleitermodulen und eine Kühleinrichtung auf, wobei die Kühleinrichtung aus einer Mehrzahl von Teilkühleinrichtungen besteht, wobei auf jeder Teilkühleinrichtung mindestens ein Leistungshalbleitermodul angeordnet ist.

Besonders bevorzugt ist es, wenn die Kühleinrichtung als Flüssigkeitskühleinrichtung ausgebildet ist und jede Teilkühleinrichtung einen Kühlkanal mit einem Zu- und einem Ablauf aufweist
Ebenso kann es vorteilhaft sein, wenn die Zuläufe der Kühlkanäle der Teilkühleinrichtungen mit einem Sammelzulauf und die Abläufe der Kühlkanäle der Teilkühleinrichtungen mit einem Sammelablauf verbunden sind und damit von einer Kühlflüssigkeit von einem Sammelzulaufanschluss des Sammelzulaufs zu einem Sammelablaufanschluss des Sammelablaufs durchströmbar sind.

Es versteht sich, dass die verschiedenen Ausgestaltungen der Erfindung einzeln oder in beliebigen Kombinationen realisiert sein können, um Verbesserungen zu erreichen. Insbesondere sind die vorstehend genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterung der Erfindung vorteilhafte Einzelheiten und Merkmale ergeben sich aus der nachfolgenden Beschreibung der in den Fig. 1 bis 8 dargestellten Ausführungsbeispiele des erfindungsgemäßen Leistungshalbleitermoduls bzw. der Anordnung hiermit.
Figur 1 zeigt schematisch ein erfindungsgemäßes Leistungshalbleitermodul.
Figur 2 zeigt ein erfindungsgemäßes Leistungshalbleitermodul im Schnitt durch eine dreidimensionale Darstellung.
Figur 3 zeigt eine schematische Ausgestaltung einer leistungselektronischen Schalteinrichtung.
Figur 4 zeigt die Schalteinrichtung gemäß Fig. 3 angeordnet zu einer Kühleinrichtung.
Figur 5 zeigt eine leistungselektronische Schalteinrichtung analog Figur 3 in dreidimensionaler Darstellung.
Figur 6 zeigt zwei leistungselektronische Schalteinrichtungen gemäß Figur 5 elektrisch leitend verbunden mit ersten Lastanschlusselementen.
Figur 7 zeigt schematisch Details der Schalteinrichtung ähnlich derjenigen gemäß Figur 6.
Figur 8 zeigt eine erfindungsgemäße Anordnung mit einer Mehrzahl von Leistungshalbleitermodulen und einer Kühleinrichtung

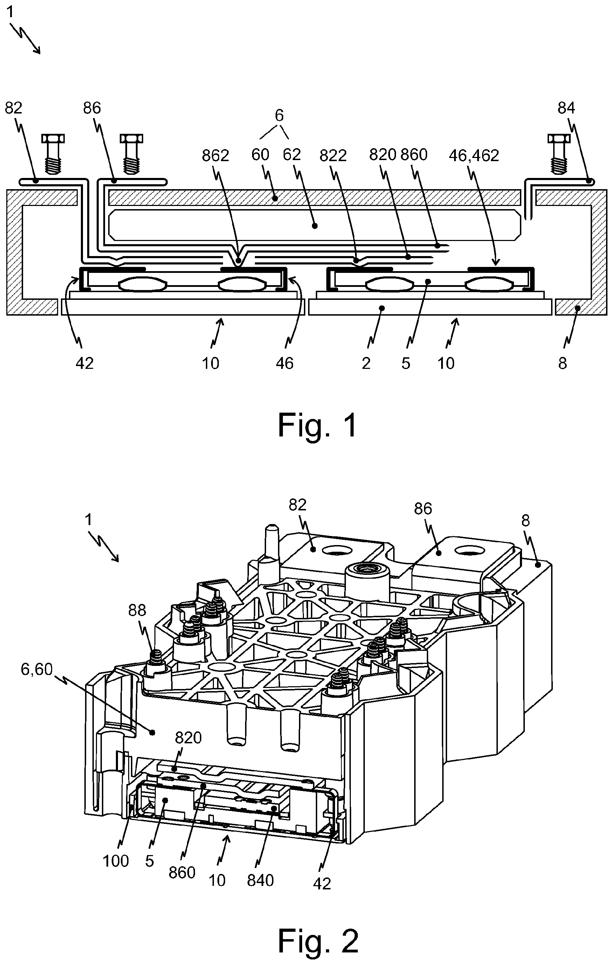

Figur 1 zeigt schematisch ein erfindungsgemäßes Leistungshalbleitermodul 1 zur druckkontaktierten Anordnung auf einem nicht dargestellten Kühlbauteil, mit einem Gehäuse 8 aus diesem heraus führenden ersten Lastanschlusselementen 82, 84, 86, einer ersten Druckeinrichtung 6 und zwei leistungselektronischen Schalteinrichtungen 10.

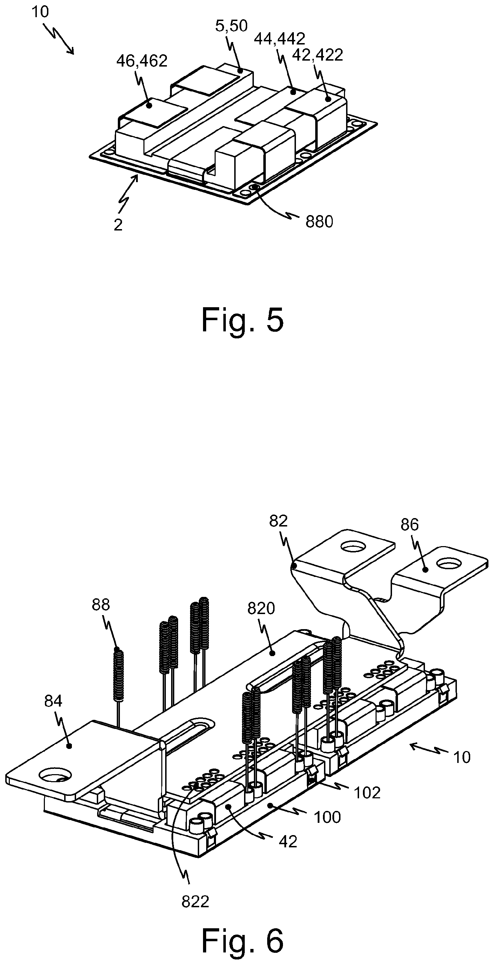

Das Gehäuse 8 ist im Wesentlichen rahmenartig ausgebildet und umschließt die leistungselektronischen Schalteinrichtungen 10, die ihrerseits jeweils zweite Lastanschlusselemente 42, 44, 46 aufweisen. Diese zweiten Lastanschlusselemente weisen zugeordnete Kontaktstellen 422, 442, 462, vgl. auch Fig. 5, auf, an denen diese mit zugeordneten ersten Lastanschlusselemente 82, 84, 86 polaritätsrichtig elektrisch leitend verbunden sind. In ihrem Verlauf durchdringen die ersten Lastanschlusselemente 82, 84, 86 das Gehäuse 8 und weisen, schematisch als Schraubverbindungen dargestellte, Anschlusseinrichtungen zur externen Verbindung auf.

Die erste Druckeinrichtung 6 des Leistungshalbleitermoduls 1 besteht hier aus einem dauerelastischen Druckspeicherelement 62 und einem mechanisch stabilen Druckstück 60, das hier gleichzeitig einen Deckel des Gehäuses 8 ausbildet. Das Druckstück 60 dient dem Aufbau und der Einleitung von Druck, während das Druckspeicherelement 62 diesen Druck auf die ersten Lastanschlusselemente 82, 84, 86 überträgt und bei wechselnden thermischen Belastungen ausgleichend wirkt. Mittels dieses Drucks wird die elektrisch leitende Verbindung der ersten 82, 84, 86 zu den zweiten Lastanschlusselementen 42, 44, 46 an entsprechenden Lastkontaktstellen 422, 442, 462 ausgebildet.

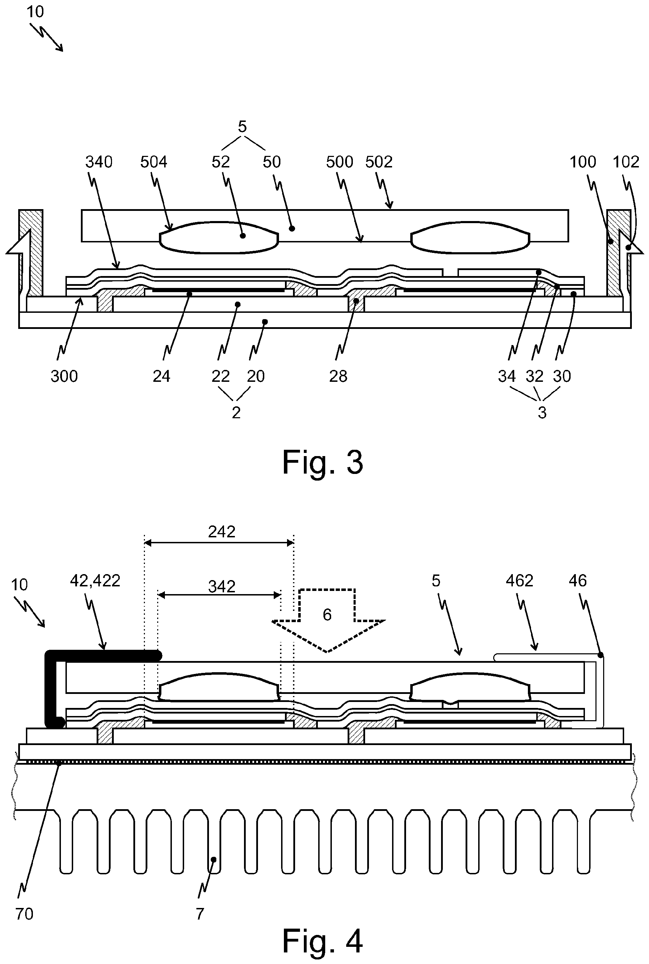

Hierbei sind die ersten Lastanschlusselemente 82, 84, 86 jeweils als elektrisch gegeneinander isolierte flächige Metallformkörper mit mindestens einem bandartigen Abschnitt 820, 860, auf den der Druck mittels der ersten Druckeinrichtung 6 ausgeübt wird, ausgebildet. Von diesen bandartigen Abschnitten gehen jeweils eine Mehrzahl von Kontaktelementen 822, 842, 862 zur Kontaktierung der Lastkontaktstellen 422, 442, 462, vgl. auch Fig. 5, aus. Die bandartigen Abschnitte 820, 840, 860 der ersten Lastanschlusselemente 82, 84, 86 sind hierbei parallel zueinander und zum Substrat 2, vgl. Fig. 3, und von diesem beabstandet angeordnet und bilden somit einen Stapel aus.

Figur 2 zeigt ein erfindungsgemäßes Leistungshalbleitermodul 1 zur druckkontaktierten Anordnung auf einem Kühlbauteil im Schnitt als dreidimensionale Darstellung. Dieses Leistungshalbleitermodul 1 entspricht im Wesentlichen dem schematisch in Fig. 1 dargestellten. Allerdings weist dieses hier dargestellte Leistungshalbleitermodul 1 eine erste Druckeinrichtung 6 auf, die keinen Druckspeicher, allerdings ein äußerst stabiles und damit verwindungssteifes Druckstück 60 aufweist. Mittels dieses Druckstücks 60 werden die ersten Lastanschlusselemente 82, 84, 86 mit Druck beaufschlag. Das Druckstück 60 ist hierzu mittels Schraubverbindungen mit dem Gehäuse 8 oder mit dem Kühlbauteil verbunden.

Weiterhin dargestellt sind fachübliche Hilfsanschlusselemente 88, ausgebildet mittels Schraubenfedern, sowie zwei externe Anschlusseinrichtungen zweier erster Lastanschlusselemente 82, 86.

Die leistungselektronischen Schalteinrichtungen 10 beider genannter Ausgestaltungen erfindungsgemäßer Leistungshalbleitermodule 1 werden im Folgenden ausführlich beschrieben.

Figur 3 zeigt eine erste Ausgestaltung einer erfindungsgemäßen leistungselektronischen Schalteinrichtung 10 ohne zweite Lastanschlusselemente. Dargestellt ist ein grundsätzlich fachüblich ausgebildetes Substrat 2 mit einem Isolierstoffkörper 20 und hierauf angeordneten jeweils elektrisch voneinander isolierten Leiterbahnen 22, die im Betrieb unterschiedliche elektrische Potentiale, insbesondere Lastpotentiale, aber auch Hilfs-, insbesondere Schalt- und Messpotentiale, der Schalteinrichtung führen. Konkret dargestellt sind hier drei Lastpotential führende Leiterbahnen 22, wie sie für eine Halbbrückentopologie typisch sind.

Auf zwei Leiterbahnen 22 ist jeweils ein Leistungsschalter 24 angeordnet, der fachüblich als Einzelschalter, beispielhaft als MOS-FET, oder als IGBT mit antiparallel geschalteter Leistungsdiode, die hier dargestellt ist, ausgebildet ist. Die Leistungsschalter 24 sind fachüblich, bevorzugt mittels einer Sinterverbindung, mit den Leiterbahnen 22 elektrisch leitend verbunden.

Die internen Verbindungen der Schalteinrichtung 10 sind ausgebildet mittels einer Verbindungseinrichtung 3 aus einem Folienverbund, der alternierend elektrisch leitende 30, 34 und elektrisch isolierende Folien 32 aufweist. Hier weist der Folienverbund genau zwei leitende 30, 34 und eine dazwischen angeordnete isolierende Folie 32 auf. Die dem Substrat 2 zugewandte Oberfläche des Folienverbunds 3 bildet hierbei die erste Hauptfläche 300 aus, während die gegenüberliegende Oberfläche die zweite Hauptfläche 340 ausbildet. Insbesondere die leitenden Folien 30, 34 der Verbindungseinrichtung 3 sind in sich strukturiert und bilden somit voneinander elektrisch isolierte Leiterbahnabschnitte aus. Diese Leiterbahnabschnitte verbinden insbesondere Leistungshalbleiterbauelemente 24, genauer deren Kontaktflächen auf der dem Substrat 2 abgewandten Seite, mit Leiterbahnen 22 des Substrats. In bevorzugter Ausgestaltung sind die Leiterbahnabschnitte mit den Kontaktstellen mittels einer Sinterverbindung stoffschlüssig verbunden. Selbstverständlich können gleichartig auch Verbindungen zwischen Leistungshalbleiterbauelementen 24 und zwischen Leiterbahnen 22 des Substrats 2 ausgebildet werden. Insbesondere bei Drucksinterverbindungen ist es vorteilhaft, wie dargestellt, eine isolierende Masse 28 am Randbereich der Leistungshalbleiterbauelement 24 anzuordnen. Diese isolierende Masse 28 kann auch in den Zwischenräumen der Leiterbahnen 22 angeordnet werden.

Die Druckeinrichtung 5 weist eine erste 500 dem Substrat 2 zugewandte und eine zweite dem Substrat 2 abgewandte Hauptfläche 502 auf und ist hier der Übersicht halber beabstandet von der Verbindungseinrichtung 3 dargestellt. Die Druckeinrichtung 5 besteht aus einem Druckkörper 50 und einer Mehrzahl, dargestellt sind hier zwei, Druckelementen 52. Der Druckkörper 50 ist besonders starr ausgebildet um auf ihn eingeleiteten Druck homogen auf die Druckelemente 52 weitergeben zu können. Hierzu und vor dem Hintergrund der thermischen Belastungen beim Betrieb der leistungselektronischen Schalteinrichtung 10 besteht der Druckkörper 50 aus einem hochtemperaturbeständigen thermoplastischen Kunststoff, insbesondere aus Polyphenylensulfid. Die Druckelemente 52 müssen im Betrieb und hierbei insbesondere bei unterschiedlichen Temperarturen einen im Wesentlichen konstanten Druck ausüben können. Hierzu bestehen die Druckelemente 52 aus einem Silikonkautschuk, insbesondere aus sog. Flüssig-Silikon.

Das Druckelement 52 besteht hier aus einem sog. Flüssig-Silikon, auch bekannt als Liquid Silicon Rubber (LSR), mit einer Shore A Härte von 20 bis 70, vorzugsweise von 30 bis 40. Diese wird mittels eines Zwei-Komponenten-Spritzgießverfahrens innerhalb des Druckkörpers 50, der aus Polyphenylensulfid besteht angeordnet. Hierzu kann das Flüssig-Silikon durch eine nicht explizit dargestellte Öffnung der zweiten Hauptfläche 502 des Druckkörpers 50 eingebracht werden.

Die erste Ausnehmung 504 des Druckkörpers 50 ist entweder ausschließlich als Vertiefung ausgehend von einer ersten Hauptfläche 500 oder als Vertiefung ausgehend von der ersten Hauptfläche 500 mit einer durch den Druckkörper 50 zur zweiten Hauptfläche 502 hindurchreichenden Aussparung mit dort ausgebildeter Öffnung ausgebildet ist. Diese zweite Variante kann herstellungstechnische Vorteil bieten.

Weiterhin weist die leistungselektronische Schalteinrichtung 10 einen Halterahmen 100 auf, der mittels eine Schnapp-Rast-Verbindung 102 in einem Gehäuse 8, vgl. Fig. 2 anordenbar ist und hierbei eine Positioniertoleranz in Normalenrichtung des Substrats 2, die identisch ist der Normalenrichtung der Leistungshalbleiterbauelemente 24, aufweist.

Figur 4 zeigt die Schalteinrichtung gemäß Fig. 3 angeordnet auf einer Kühleinrichtung 7 und eine schematisch angedeutete erste Druckeinrichtung 6. Die erste Druckeinrichtung 6 stützt sich, nicht dargestellt, gegen die Kühleinrichtung 7, ab. Dies kann mittelbar beispielhaft über eine Schraubverbindung zwischen der Druckeinleiteinrichtung und einem auf der Kühleinrichtung 7 befestigten Gehäuse 8, vgl. Fig. 2, ausgeführt sein.

Die erste Druckeinrichtung 6 drückt hierbei mittelbar auf die zweite Druckeinrichtung 5 der leistungselektronischen Schalteinrichtung 10. Der Druckkörper 50 der zweiten Druckeinrichtung 5 verteilt den Druck gleichmäßig auf die Druckelemente 52, die ihrerseits auf Abschnitte 342 der zweiten Hauptfläche 340 der Verbindungseinrichtung 3 drücken. Diese Abschnitte 342 der Verbindungseinrichtung 3, die mit Druck beaufschlagt werden sind erfindungsgemäß derart gewählt, dass sie und somit ihre Ausdehnungsfläche betrachtet in Normalenrichtung des zugeordneten Leistungshalbleiterbauelements 24 innerhalb der Fläche 242 dieses Leistungshalbleiterbauelements 24 angeordnete sind. Somit drückt das Druckelement 52 mittels der Verbindungseinrichtung 3 derart auf das Leistungshalbleiterbauelement 24, dass dieses, genauer das darunter befindliche Substrat 2, auf den Kühlkörper 7 gedrückt wird und somit der thermische Kontakt vom Leistungshalbleiterbauelement 24 zum Kühlkörper 7 optimal ausgebildet ist. Durch diese Druckeinleitung auf die Druckelemente 52 verformen sich diese, wobei es hierbei auch möglich ist, dass ihre laterale Ausdehnung 342, gegenüber dem nicht mit Druck beaufschlagten Zustand gemäß Fig. 3, zunimmt.

Zur elektrischen Anbindung weist die leistungselektronische Schalteinrichtung 10 zweite Lastanschlusselemente 42, 46 und Hilfsanschlusselemente auf, wobei hiervon nur die Lastanschlusselemente dargestellt sind. Diese zweiten Lastanschlusselemente 42, 44, 46 sind beispielhaft wie dargestellt als Metallformkörper ausgebildet, der mit einem Kontaktfuß mit einer Leiterbahn 22 des Substrats 2 stoffschlüssig, vorteilhafterweise ebenfalls mittels einer Sinterverbindung, verbunden sind. Grundsätzlich können wie ebenfalls dargestellt Teile der Verbindungseinrichtung 3 selbst, also Abschnitte elektrisch leitender Folien 30, als Last- oder Hilfsanschlusselemente ausgebildet sein. Die Hilfsanschlusselemente, wie Gate- oder Sensoranschlüsse, können im Übrigen auch fachüblich ausgebildet sein.

Zur thermischen Anbindung des Leistungshalbleiterbauelements 24 an den Kühlkörper 7 wird Druck mittels der ersten Druckeinrichtung 6 auf die ersten Lastanschlusselemente 82, 84, 86, vgl. Fig. 1, über diese auf Lastkontaktstellen 422, 442, 462 der zweiten Lastanschlusselemente 42, 44, 46, über die zweite Druckeinrichtung 5 und die Verbindungseinrichtung 3 auf das Leistungshalbleiterbauelement 24 übertragen. Dieses wird somit mit dem Substrat 2 auf den Kühlkörper 7 gedrückt.

Zwischen dem Substrat 2 und dem Kühlkörper 7 ist eine Wärmeleitpaste 70 mit einer Dicke von weniger als 10µm angeordnet. Ein derart dünne Ausgestaltung einer Wärmeleitpastenschicht 70 ist unter Berücksichtigung latent vorhandener lokaler Durchbiegungen des Substrats 2 insbesondere dadurch möglich, dass der Druck in Normalenrichtung auf das Leistungshalbleiterbauelement 24 eingeleitet wird und somit das Leistungshalbleiterbauelement 24 und nicht eine das Leistungshalbleiterbauelement umgebende Fläche des Substrats den optimalen thermischen Kontakt zum Kühlkörper 7 aufweist.

Die Kühleinrichtung ist hier als Kühlkörper 7 zur Luftkühlung dargestellt, kann aber genauso als Grundplatte eines Leistungshalbleitermoduls oder als Kühlkörper zur Flüssigkeitskühlung ausgebildet sein.

Figur 5 zeigt eine leistungselektronische Schalteinrichtung 10 ähnlich derjenigen gemäß Figur 3 in dreidimensionaler Darstellung. Wesentlich ist hier, dass der Druckkörper 50 eine gestufte Oberfläche aufweist. Auf dieser Oberfläche kommen diejenigen Abschnitte der zweiten Lastanschlusselemente 42, 44, 46 zu liegen, die auf ihrer dieser Oberfläche abgewandten Seite die Lastkontaktstellen 422, 442, 462 aufweisen. Hier dargestellt sind für jedes Potential zwei Lastanschlusselemente, die jeweils auf einer eigenen Ebene der Oberfläche des Druckkörpers 50 angeordnet sind. Auf dem Substrat 2 sind zusätzliche Hilfskontaktstellen 880 dargestellt, die der Konstatierung mit Hilfskontaktfedern dienen.

Figur 6 zeigt zwei leistungselektronischen Schalteinrichtungen 10 gemäß Figur 5 jeweils elektrisch leitend verbunden mit ersten Lastanschlusselementen 82, 84, 86. Die leistungselektronischen Schalteinrichtungen 10 entsprechen derjenigen gemäß Fig. 5 und weisen hier zusätzlich je einen Halterahmen 100 auf, der mittels Schnapp-Rast-Verbindungen 102, hiervon dargestellt die Rastnasen, in einem Gehäuse 8, vgl. Fig. 2, des Leistungshalbleitermoduls 1 anordenbar sind.

Die ersten Lastanschlusselemente 82, 84, 86 weisen drei unterschiedliche elektrische Potentiale auf, beispielhaft zur Ausbildung einer fachüblichen Halbbrückentopologie mit zwei Gleichspannungsanschlusselemente 82, 86 mit positivem bzw. negativem Potential und mit einem Wechselspannungsanschlusselement 84.

Dieses ersten Lastanschlusselemente 82, 84, 86 weisen jeweils zur polaritätsrichtigen Kontaktierung von Lastkontaktstellen 422, 442, 462 der zugeordneten zweiten Lastanschlusselemente 42, 44, 46 eine Mehrzahl von Kontaktelementen 822, 842 auf, die jeweils als prägetechnisch ausgebildete Kontaktnoppen 822, 842, 862 ausgebildet sind.

Weiterhin dargestellt sind fachübliche Hilfskontaktfedern 88 die in Führungen des ersten Druckkörpers 60, vgl. Fig. 2, angeordnet sind und der externen Kontaktierung insbesondere von Gateanschlüssen und von internen Sensoren, wie Temperatur- oder Stromsensoren, dienen.

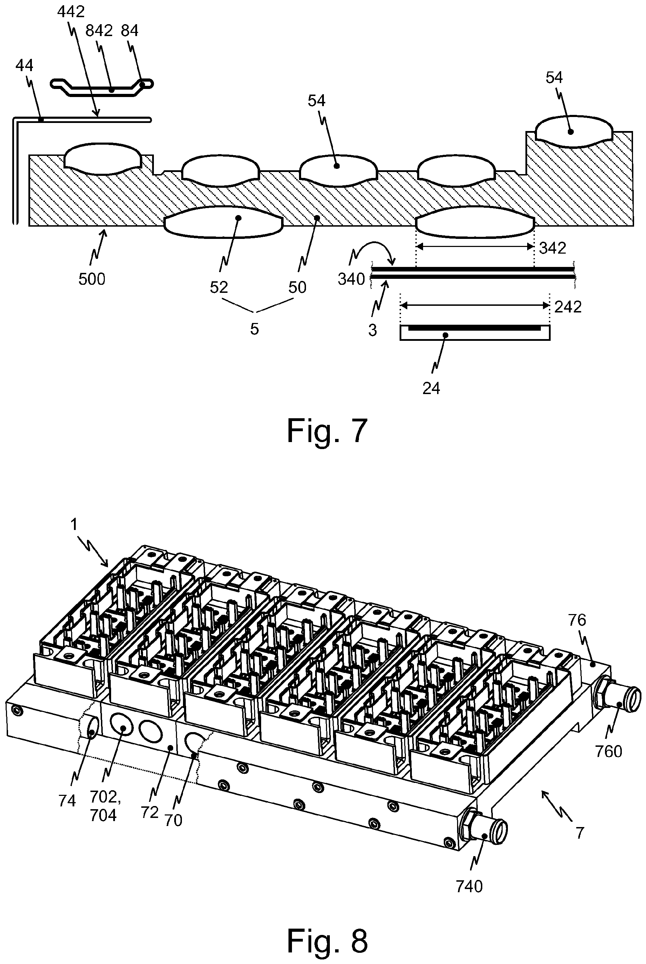

Figur 7 zeigt schematisch ähnlich einer Explosionszeichnung ausgewählte Details der leistungselektronischen Schalteinrichtung vergleichbar derjenigen gemäß Figur 6. Dargestellt ist eine zweite Druckeinrichtung 5 mit einem Druckkörper 50 der eine erste Hauptfläche 500 aufweist von der erste Druckelement 52, wie oben beschrieben, hervorstehen. Für eines dieser ersten Druckelemente 52 ist ein zugeordneter Abschnitt der Verbindungseinrichtung 3 und ein zugeordnetes Leistungshalbleiterbauelement 24 dargestellt. Das erste Druckelement 52 ist dazu ausgebildet auf einen Abschnitt 342 der zweiten Hauptfläche 340 der Verbindungseinrichtung 3 zu drücken wobei dieser Abschnitt in Projektion entlang der Normalenrichtung des Leistungshalbleiterbauelements 24 innerhalb der Fläche 242 des Leistungshalbleiterbauelements 24 angeordnet ist. In anderen Worten bedeutet dies, dass in dieser Normalenrichtung die Fläche auf die das Druckelement drückt kleiner ist als die Grenzen des Leistungshalbleiterbauelements 24. Hierdurch wird also nur auf das Leistungshalbleiterbauelement 24, nicht auf benachbarte Substratbereiche, Druck ausgeübt. Hierbei entspricht der Flächeninhalt des Abschnitts 342 der Verbindungseinrichtung 3 mindestens 20%, insbesondere mindestens 50% des Flächeninhalts der Fläche 242 des Leistungshalbleiterbauelements 24.

Weiterhin sind im Gegensatz zur Ausgestaltung gemäß Fig. 6 zweite Druckelemente 54 in zweiten Ausnehmungen des Druckkörpers 50 auf den Stufen der dem Substrat, bzw. dem Leistungshalbleiterbauelement 24, abgewandten Oberfläche angeordnet, die in Richtung der ersten Lastanschlusselement 82, 84, 86 aus dem Druckkörper 50 hervorstehen. Diese zweiten Druckelemente 54 dienen ebenfalls dem Druckaufbau und können einen Druckspeicherelement 62, vgl. Fig. 1, ersetzen oder ergänzen.

Dargestellt ist ebenso ein erstes 84 und ein zweites Lastanschlusselement 44. Das erste Lastanschlusselement 84 weist hierbei ein Kontaktelement 842 zur elektrischen Verbindung mit einer zugeordneten Kontaktstelle 442 des zweiten Lastanschlusselements 44 auf.

Figur 8 zeigt eine erfindungsgemäße Anordnung mit einer Mehrzahl von Leistungshalbleitermodulen 1 und einer Kühleinrichtung 7, wobei die Kühleinrichtung 7 aus einer Mehrzahl von Teilkühleinrichtungen 70, 72 besteht. Hier ist auf jeder Teilkühleinrichtung 70, 72 genau ein Leistungshalbleitermodul 1 angeordnet. Es können allerdings ebenso mehrere Leistungshalbleitermodul auf einer Teilkühleinrichtung angeordnet sein. Die Teilkühleinrichtungen 70, 72 sind mit ihren Längsseiten aneinandergereiht.

Die Kühleinrichtung 7 ist hier als Flüssigkeitskühleinrichtung ausgebildet ist, wobei jede Teilkühleinrichtung 70, 72 einen Kühlkanal 702 mit einem Zu- 704 und einem Ablauf aufweist. Der jeweilige Zulauf 704 der Kühlkanäle 702 der Teilkühleinrichtungen 70, 72 ist mit einem Sammelzulauf 74 und der jeweilige Ablauf der Kühlkanäle 702 der Teilkühleinrichtungen 70, 72 mit einem Sammelablauf 76 verbunden. Der Sammelzulauf 74 ist hier an ersten Schmalseiten der Teilkühleinrichtungen 70, 72 angeordnet, während der Sammelablauf 76 an den gegenüberliegenden Schmalseiten der Teilkühleinrichtungen 70, 72 angeordnet ist.

Der Sammelzulauf 74 weist einen Sammelzulaufanschluss 740 und der Sammelablauf 76 einen Sammelablaufanschluss 760 auf. Die Kühleinrichtung 7 ist somit von dem Sammelzulaufanschluss 740 über den Sammelzulauf 74 durch die strömungstechnisch parallel geschalteten Teilkühleinrichtungen 70, 72 zum Sammelablauf 76 und dem Sammelablaufanschluss 760 mit Kühlflüssigkeit durchströmbar.

## Patentansprüche

1. Leistungshalbleitermodul (1) in Druckkontaktausführung, zur Anordnung auf einem Kühlbauteil (7), mit einer leistungselektronischen Schalteinrichtung (10), einem Gehäuse (8), mit aus diesem nach außen führenden ersten Lastanschlusselementen (82, 84, 86) und mit einer ersten Druckeinrichtung (6), wobei die leistungselektronische Schalteinrichtung (10) ein Substrat (2) mit einem hierauf angeordneten Leistungshalbleiterbauelement (24, 26), eine interne Verbindungseinrichtung (3), interne zweite Lastanschlusselemente (42, 44, 46) und eine zweite Druckeinrichtung (5), aufweist,
wobei die Verbindungseinrichtung (3) als Folienverbund mit einer elektrisch leitenden (30, 34) und einer elektrisch isolierenden Folie (32) ausgebildet ist und somit eine erste und eine zweite Hauptfläche (300, 340) ausbildet und wobei die Schalteinrichtung (10) mittels der Verbindungseinrichtung (3) schaltungsgerecht intern elektrisch verbunden ist,
wobei die zweite Druckeinrichtung (5) einen Druckkörper (50) mit einer ersten Ausnehmung (504) aufweist aus der ein erstes Druckelement (52) in Richtung des Leistungshalbleiterbauelements (24, 26) hervorstehend angeordnet ist und wobei das Druckelement (52) auf einen Abschnitt (342) der zweiten Hauptfläche (340) der Verbindungseinrichtung (3) drückt und hierbei dieser Abschnitt in Projektion entlang der Normalenrichtung des Leistungshalbleiterbauelements (24, 26) innerhalb der Fläche (242) des Leistungshalbleiterbauelements (24) angeordnet ist,
wobei die ersten Lastanschlusselemente (82, 84, 86) mit auf der Oberseite des Druckkörpers (50) angeordneten Lastkontaktstellen (422, 442, 462) der zweiten
Lastanschlusselemente (42, 44, 46) polaritätsgerecht direkt elektrisch verbunden sind, wobei
zur thermischen Anbindung des Leistungshalbleiterbauelements (24) an das Kühlbauteil (7) die erste Druckeinrichtung (6) ausgebildet ist zur Druckeinleitung auf die ersten Lastanschlusselemente (82, 84, 86), über diese auf die zweiten Lastanschlusselemente (42, 44, 46), weiter über die zweite Druckeinrichtung (5) und die Verbindungseinrichtung (3) auf das Leistungshalbleiterbauelement (24).

2. Leistungshalbleitermodul nach Anspruch 1 oder 2, wobei die ersten Lastanschlusselemente (82, 84, 86) jeweils als elektrisch gegeneinander isolierte flächige Metallformkörper mit mindestens einem bandartigen Abschnitt (820, 860) mit einer Mehrzahl von diesem ausgehenden Kontaktelementen (822, 842) zur Kontaktierung der Lastkontaktstellen (422, 442, 462) ausgebildet sind, wobei die bandartigen Abschnitte (820, 840, 860) der ersten Lastanschlusselemente (82, 84, 86) parallel zum Substrat und von diesem beabstandet angeordnet sind und somit einen Stapel ausbilden.

3. Leistungshalbleitermodul nach einem der vorhergehenden Ansprüche, wobei das Substrat (2) gegeneinander elektrisch isolierte Leiterbahnen (22) aufweist und auf einer Leiterbahn (22) das Leistungshalbleiterbauelement (24) angeordnet und stoffschlüssig damit verbunden ist.

4. Leistungshalbleitermodul nach einem der vorhergehenden Ansprüche, wobei der Druckkörper (50) aus einem hochtemperaturbeständigen thermoplastischen Kunststoff, insbesondere aus Polyphenylensulfid, und das Druckelement (52) aus einem Silikonkautschuk, insbesondere aus Flüssig-Silikon, besteht.

5. Leistungshalbleitermodul nach einem der vorhergehenden Ansprüche, wobei der Druckkörper (50) der zweiten Druckeinrichtung (5) eine zweite Ausnehmung aufweist aus der ein zweites Druckelement (54) in Richtung der ersten Lastanschlusselemente (82, 84, 86) hervorstehend angeordnet ist.

6. Leistungshalbleitermodul nach einem der vorhergehenden Ansprüche, wobei der Flächeninhalt des Abschnitts (342) der Verbindungseinrichtung (3) mindestens 20%, insbesondere mindestens 50% der Fläche (242) des Leistungshalbleiterbauelements (24) aufweist.

7. Leistungshalbleitermodul nach einem der vorhergehenden Ansprüche, wobei die leistungselektronische Schalteinrichtung (10) einen Halterahmen (100) aufweist, der mittels eine Schnapp-Rast-Verbindung (102) in dem Gehäuse (8) angeordnet ist.

8. Anordnung mit einer Mehrzahl von Leistungshalbleitermodulen (1), jeweils nach einem der vorhergehenden Ansprüche und mit einer Kühleinrichtung (7), wobei die Kühleinrichtung (7) aus einer Mehrzahl von Teilkühleinrichtungen (70, 72) besteht, wobei auf jeder Teilkühleinrichtung (70, 72) mindestens ein Leistungshalbleitermodul (1) angeordnet ist.

9. Anordnung nach Anspruch 9, wobei
die Kühleinrichtung (7) als Flüssigkeitskühleinrichtung ausgebildet ist und jede Teilkühleinrichtung (70, 72) einen Kühlkanal (702) mit einem Zu- (704) und einem Ablauf aufweist.

10. Anordnung nach Anspruch 9 oder 10, wobei
die Zuläufe (704) der Kühlkanäle (702) der Teilkühleinrichtungen (70, 72) mit einem Sammelzulauf (74) und die Abläufe der Kühlkanäle (702) der Teilkühleinrichtungen (70, 72) mit einem Sammelablauf (76) verbunden und damit von einer Kühlflüssigkeit von einem Sammelzulaufanschluss (740) des Sammelzulaufs (74) zu einem Sammelablaufanschluss (760) des Sammelablaufs (76) durchströmbar sind.

## Claims

1. Power semiconductor module (1) of a pressure contact configuration, for arrangement on a cooling component (7), with a power-electronic switching device (10), a housing (8), with first load terminal elements (82, 84, 86) leading out of this housing to the outside and with a first pressure device (6), wherein
the power-electronic switching device (10) has a substrate (2) with a power semiconductor component (24, 26) arranged on it, an internal connecting device (3), internal second load terminal elements (42, 44, 46) and a second pressure device (5), wherein the connecting device (3) is formed as a film composite with an electrically conducting film (30, 34) and an electrically insulating film (32), and consequently forms a first and a second main area (300, 340) and wherein the switching device (10) is electrically connected internally to meet switching requirements by means of the connecting device (3),
wherein the second pressure device (5) has a pressure body (50) with a first recess (504), from which a first pressure element (52) is arranged protruding in the direction of the power semiconductor component (24, 26) and
wherein the pressure element (52) presses against a portion (342) of the second main area (340) of the connecting device (3) and this portion is thereby arranged in projection along the direction normal to the power semiconductor component (24, 26) within the area (242) of the power semiconductor component (24),
wherein the first load terminal elements (82, 84, 86) are electrically connected directly to meet polarity requirements to load contact points (422, 442, 462) of the second load terminal elements (42, 44, 46) arranged on the upper side of the pressure body (50), wherein the first pressure device (6) is formed for the thermal attachment of the power semiconductor component (24) to the cooling component (7) for introducing pressure to the first load terminal elements (82, 84, 86), via the latter to the second load terminal elements (42, 44, 46), and on via the second pressure device (5) and the connecting device (3) to the power semiconductor component (24).

2. Power semiconductor module according to Claim 1 or 2, wherein the first load terminal elements (82, 84, 86) are respectively formed as sheet-like shaped metal bodies that are electrically insulated from one another and have at least one strip-like portion (820, 860) with a plurality of contact elements (822, 842) extending from it for contacting the load contact points (422, 442, 462), wherein the strip-like portions (820, 840, 860) of the first load terminal elements (82, 84, 86) are arranged parallel to the substrate and at a distance from it, and consequently form a stack.

3. Power semiconductor module according to one of the preceding claims, wherein the substrate (2) has conductor tracks (22) that are electrically insulated from one another and the power semiconductor component (24) is arranged on a conductor track (22) and is connected to it in a materially-bonded manner.

4. Power semiconductor module according to one of the preceding claims, wherein the pressure body (50) consists of a high-temperature-resistant thermoplastic material, in particular of polyphenylene sulfide, and the pressure element (52) consists of a silicone rubber, in particular of liquid silicone.

5. Power semiconductor module according to one of the preceding claims, wherein the pressure body (50) of the second pressure device (5) has a second recess, from which a second pressure element (54) is arranged protruding in the direction of the first load terminal elements (82, 84, 86).

6. Power semiconductor module according to one of the preceding claims, wherein the area content of the portion (342) of the connecting device (3) comprises at least 20%, in particular at least 50%, of the area (242) of the power semiconductor component (24).

7. Power semiconductor module according to one of the preceding claims, wherein the power-electronic switching device (10) has a holding frame (100), which is arranged in the housing (8) by means of a snap-lock connection (102).

8. Assembly with a plurality of power semiconductor modules (1), respectively according to one of the preceding claims and with a cooling device (7), wherein the cooling device (7) consists of a plurality of part cooling devices (70, 72), wherein at least one power semiconductor module (1) is arranged on each part cooling device (70, 72).

9. Assembly according to Claim 9, wherein
the cooling device (7) is formed as a liquid cooling device and each part cooling device (70, 72) has a cooling channel (702) with an inflow (704) and an outflow.

10. Assembly according to Claim 9 or 10, wherein
the inflows (704) of the cooling channels (702) of the part cooling devices (70, 72) are connected to a collecting inflow (74) and the outflows of the cooling channels (702) of the part cooling devices (70, 72) are connected to a collecting outflow (76), and consequently can be flowed through by a cooling liquid from a collecting inflow connection (740) of the collecting inflow (74) to a collecting outflow connection (760) of the collecting outflow (76) .

## Revendications

1. Module semi-conducteur de puissance (1) conçu comme contact de pression, pour agencement à un composant de refroidissement (7), doté d'un dispositif commutateur d'électronique de puissance (10), un boîtier (8), doté d'un premier groupe d'éléments de branchement de charge (82, 84, 86) sortant de celui-ci et doté d'un premier moyen de pression (6), dans lequel le dispositif commutateur d'électronique de puissance (10) comporte un substrat (2) sur lequel est disposé un composant semi-conducteur de puissance (24, 26), un moyen de raccordement interne (3), un second groupe d'éléments de branchement de charge (42, 44, 46) internes et un second moyen interne de pression (5), dans lequel le moyen de raccordement (3) est conçu comme film composite doté d'une couche électriquement conductrice (30, 34) et d'une couche électriquement isolante (32) et forme ainsi une première et une seconde surface principale (300, 340) et dans lequel le dispositif commutateur (10) est raccordé électriquement conformément au circuit par le biais du moyen de raccordement (3),
dans lequel le second moyen de pression (5) comporte un corps de pression (50) doté d'une première cavité (504), dans laquelle un premier élément de pression (52) est arrangé en saillie dans la direction du composant semi-conducteur de puissance (24, 26) et dans lequel l'élément de pression (52) appuie sur une section (342) de la seconde surface principale (340) du moyen de raccordement (3) et en faisant cela cette section est agencée en projection le long de la direction normale du composant semi-conducteur de puissance (24, 26) à l'intérieur de la surface (242) du composant semi-conducteur de puissance (24),
dans lequel le premier groupe d'éléments de branchement de charge (82, 84, 86) est raccordé électriquement directement, conformément à la polarité, aux contacts de charge (422, 442, 462), disposés sur la face supérieure du corps de pression (50), du second groupe d'éléments de branchement de charge (42, 44, 46),
dans lequel, afin d'assurer la connexion thermique du composant semi-conducteur de puissance (24) au composant de refroidissement (7), le premier moyen de pression (6) est conçu pour exercer une pression sur le premier groupe d'éléments de branchement de charge (82, 84, 86), par ceux-ci sur le second groupe d'éléments de branchement de charge (42, 44, 46), et par le second moyen de pression (5) et le moyen de raccordement (3) sur le composant semi-conducteur de puissance (24).

2. Module semi-conducteur de puissance selon la revendication 1 ou 2, dans lequel les éléments de branchement de charge du premier groupe (82, 84, 86) sont chacun conçus comme des pièces métalliques électriquement isolées l'une de l'autre spatialement dotées d'au moins une section semblable à une bande (820, 860) et conçus pour être en contact avec les contacts de charge (422, 442, 462) au moyen d'une majorité de ces éléments de contact sortants (822, 842), dans lequel les sections semblables à des bandes (820, 840, 860) du premier groupe d'éléments de branchement de charge (82, 84, 86) sont agencées parallèlement au substrat et écartées de celui-ci et forment ainsi un empilement.

3. Module semi-conducteur de puissance selon l'une des revendications précédentes, dans lequel le substrat (2) comporte des bandes conductrices (22) isolées électriquement l'une par rapport à l'autre et est agencé par une bande conductrice (22) au composant semi-conducteur de puissance (24) et y est raccordé par liaison de matière.

4. Module semi-conducteur de puissance selon l'une des revendications précédentes, dans lequel le corps de pression (50) est constitué d'un plastique thermoplastique résistant aux températures élevées, en particulier de polysulfure de phénylène, et l'élément de pression (52) est constitué de caoutchouc silicone, en particulier de silicone liquide.

5. Module semi-conducteur de puissance selon l'une des revendications précédentes, dans lequel le corps de pression (50) du second moyen de pression (5) comporte une seconde cavité dans laquelle un second élément de pression (54) est arrangé en saillie dans la direction du premier groupe d'éléments de branchement de charge (82, 84, 86).

6. Module semi-conducteur de puissance selon l'une des revendications précédentes, dans lequel la surface de la section (342) du moyen de raccordement (3) comporte au moins 20 %, de préférence au moins 50 %, de la surface (242) du composant semi-conducteur de puissance (24) .

7. Module semi-conducteur de puissance selon l'une des revendications précédentes, dans lequel le dispositif commutateur d'électronique de puissance (10) comporte un cadre de maintien (100), lequel est agencé dans le boîtier (8) au moyen d'un raccordement à encliquetage élastique (102) .

8. Arrangement avec une majorité de modules semiconducteurs de puissance (1), chacun selon l'une des revendications précédentes, et avec un dispositif de refroidissement (7), dans lequel le dispositif de refroidissement (7) est constitué d'une majorité de modules de refroidissement (70, 72), dans lequel au moins un module semi-conducteur de puissance (1) est agencé sur chaque module de refroidissement (70, 72).

9. Arrangement selon la revendication 9, dans lequel le dispositif de refroidissement (7) est conçu comme dispositif de refroidissement liquide et chaque module de refroidissement (70, 72) comporte un tunnel de refroidissement (702) doté d'une arrivée (704) et d'une sortie.

10. Arrangement selon la revendication 9 ou 10, dans lequel les arrivées (704) des tunnels de refroidissement (702) des modules de refroidissement (70, 72) sont raccordées à une arrivée commune (74) et les sorties des tunnels de refroidissement (702) des modules de refroidissement (70, 72) sont raccordées à une sortie commune (76), avec lesquelles un fluide de refroidissement peut circuler depuis un raccordement d'entrée (740) de l'arrivée commune (74) jusqu'à un raccordement de sortie (760) de la sortie commune (76).
